# EUROPEAN PATENT APPLICATION

(11) **EP 1 077 589 A2**
(43) Date of publication of application: **21.02.2001**
(21) Application number: 00117632.0
(22) Date of filing: 16.08.2000
(51) Int. Cl.: H05B 33/04, H05B 33/22

(54) **Organic EL display device**

(30) Priority: 19.08.1999 JP 23246799
(71) Applicant: Harness System Technologies Research, Ltd., Nagoya-shi, Aichi (JP); SUMITOMO WIRING SYSTEMS, Ltd., Yokkaichi-shi, Mie-ken 510 (JP); SUMITOMO ELECTRIC INDUSTRIES, LTD., Osaka-shi, Osaka 544-8511 (JP)
(72) Inventor: Tokunaga, Masahiro, Harness System Tech. Res. Ltd, Nagoya-shi, Aichi (JP); Ono, Junichi, Harness System Tech. Research Ltd.,, Nagoya-shi, Aichi (JP)
(74) Representative: Kuhnen & Wacker

(57) **Abstract**

An organic EL display device 1 is mainly configured by: a transparent substrate 2; an organic EL element 3 which is formed on the rear face of the transparent substrate 2; an optical filter 4 which is disposed on the front face of the transparent substrate 2; a sealing case 5 (sealing member); and a visible light absorbing member 6 which is placed on the side of the inner face of the sealing case 5. With respect to extraneous, light 17 and 17a which enters through a display face 14, the extraneous light 17 which is reflected by a front face 18 of a back electrode 12 to advance toward the display face 14 is blocked by the optical filter 4, and the extraneous light 17a which passes through a division gap 23 of the back electrode 12 is absorbed by the visible light absorbing member 6 so as not leak out to the outside through the display face 14. Therefore, the division line is prevented from being displayed on the display face.

## Description

### BACKGROUND OF THE INVENTION

The present invention relates to an organic EL display device which is used in various kinds of displays, and particularly to an organic EL display device in which a back electrode is divided into plural portions, and which is used as a dynamic driving type.

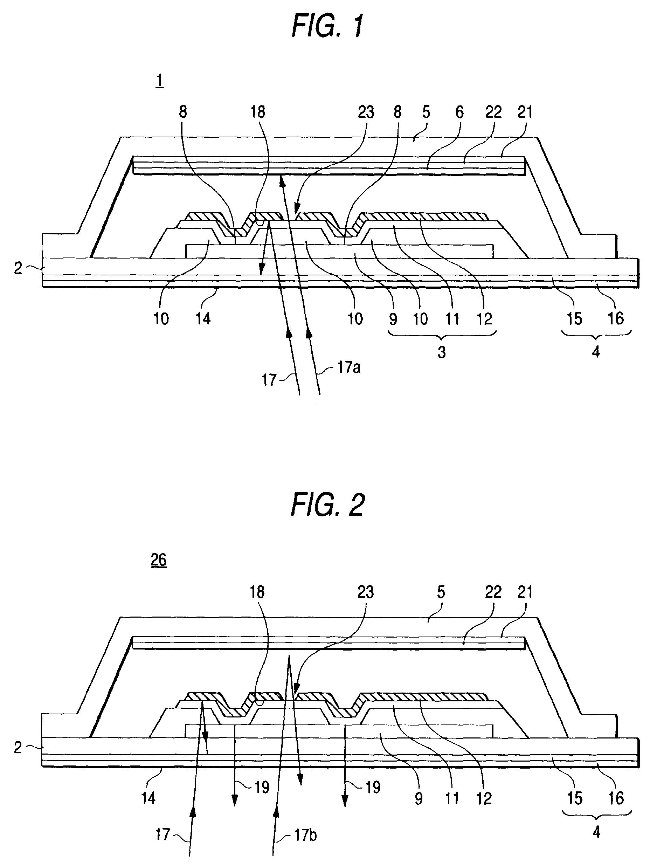

Fig. 2 shows an organic EL display device which is usually used in the conventional art.

The organic EL display device 26 is usually configured in the following manner. A transparent electrode 9 serving as an anode is formed on a transparent substrate 2. An organic layer 11 consisting of one more kinds of layers is formed on the electrode. A non-transparent back electrode 12 serving as a cathode is stacked on the layer. A sealing case 5 is placed on the transparent substrate 2 so as to cover these components.

A moisture proofing agent 21 is placed on the inner face of the sealing case 5, and covered by an agent scatter preventing film 22 which is usually white, so as not to scatter. An optical filter 4 configured by a quarter-wave plate 15 and a polarizing plate 16 is bonded to the front face of the transparent substrate 2. Extraneous light 17 which enters the organic EL display device 26 through a display face 14 is caused to pass through the polarizing plate 16 so as to be converted into linearly polarized light, then pass through the quarter-wave plate 15 to be reflected by the front face 18 of the back electrode 12, and thereafter again pass through the quarter-wave plate 15, whereby the polarization direction of the light is set to be perpendicular to that of the polarizing plate 16, so that the light is blocked by the polarizing plate 16 from exiting to the outside. By contrast, with respect to light 19 emitted from the organic layer 11, an approximately half portion of the light is not blocked and is allowed to exit from the display face 14 because the light is not polarized.

In this way, the contrast of a figure displayed on the display face 14 can be improved.

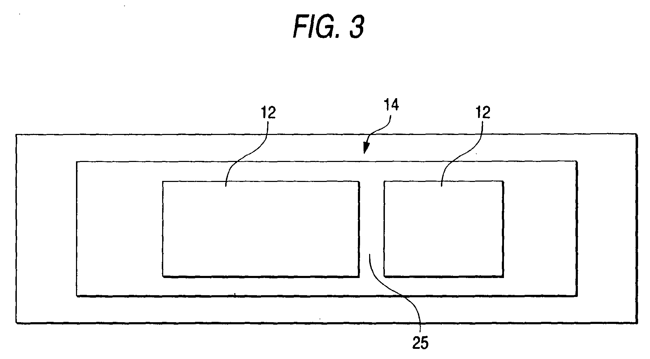

The thus configured organic EL display device 26 is driven by either of the static driving method, and the dynamic driving method. In the case where the dynamic driving method is used, the back electrode 12 of the organic EL display device 26 must be formed so as to be divided into plural portions as shown in Figs. 2 and 3.

When the electrode structure wherein the back electrode 12 is divided is employed in the above configuration, there arises a problem as described below. With respect to extraneous light 17 and 17b which enters from the outside through the display face 14, the extraneous light 17 which is reflected by the front face 18 of the back electrode 12 so as to advance toward the display face 14 is blocked by the optical filter 4 as described above. In the extraneous light 17b which is irregularly reflected by the surface of the agent scatter preventing filter 22 placed in rear of the back electrode 12, the polarizing plane is made random by the irregular reflection, and a portion which passes through the division gap 23 of the back electrode 12 is not completely blocked by the optical filter 4 to exit from the display face 14. As a result, as shown in Fig. 3, the back electrode 12 is displayed in black, and the division gap 25 of the back electrode 12 is brightly displayed by the extraneous light 17b, so that the division portion of the back electrode 12 is viewed as a division line, thereby causing a defect that the visuality of the display device is lowered.

### SUMMARY OF THE INVENTION

It is an object of the invention to provide an organic EL display device in which, even when an electrode structure wherein a back electrode is divided is employed, extraneous light entering through a display face is caused to be irregularly reflected in the side of an inner face of a sealing case, thereby preventing a division line of the back electrode from being displayed on the display face.

In order to attain the object, the organic EL display device of the invention comprises: a transparent substrate; an organic EL element which is formed on the transparent substrate, and in which a non-transparent back electrode is dividedly formed; a sealing member which is disposed on the transparent substrate to cover the organic EL element; and a visible light absorbing member which is placed in a rear position with respect to a division line of the back electrode.

Preferably, the visible light absorbing member is placed on an inner face of the sealing member, and is one of black paper, black nonwoven fabric, a resin into which a black pigment is mixed, and a resin a surface of which is colored with black.

The display device may further comprise: a moisture proofing agent which is placed on an inner face of the sealing member; and an agent scatter preventing filter which is coveringly placed on a surface of the moisture proofing agent, and the visible light absorbing member may be formed as a black filter, and coveringly placed on the agent scatter preventing filter.

Alternatively, the display device may further comprise a moisture proofing agent which is placed on an inner face of the sealing member, and the visible light absorbing member may be formed as a black agent scatter preventing filter, and coveringly placed on a surface of the moisture proofing agent.

### BRIEF DESCRIPTION OF THE DRAWINGS

Fig. 1 is a section view of an organic EL display device which is a first embodiment of the invention.
Fig. 2 is a section view of an organic EL display device of the conventional art.
Fig. 3 is a view of a display face of the organic EL display device of the conventional art, as seen from the front side.

### DETAILED DESCRIPTION OF THE PREFERRED EMBODIMENTS

Hereinafter, an organic EL display device which is a first embodiment of the invention will be described with reference to Fig. 1. Fig. 1 is a section view of the organic EL display device of the embodiment.

As shown in Fig. 1, the organic EL display device 1 of the embodiment is mainly configured by: a transparent substrate 2 such as a glass substrate; an organic EL element 3 which is formed on the rear face of the transparent substrate 2; an optical filter 4 which is disposed on the front face of the transparent substrate 2; a sealing case 5 (sealing member) which is placed on the transparent substrate 2 so as to cover the organic EL element 3; and a visible light absorbing member 6 which is placed on the side of the inner face of the sealing case 5.

The organic EL element 3 is formed by forming a transparent electrode 9 made of indium-tin-oxide (ITO) as an anode on the rear face of the transparent substrate 2, and sequentially stacking on the transparent electrode an insulating layer 10 which defines the outline of each segment 8, an organic layer 11, and a non-transparent back electrode 12 which is formed as a cathode and made of aluminum or the like. The organic layer 11 is configured by, for example, three layers, or an electron transporting layer made of a binuclear zinc complex, a hole transporting layer made of an amine compound, and a light emitting layer which is sandwiched by the two layers and made of quinolinol aluminum complex or the like.

The organic EL element 3 is driven by the dynamic driving method. Therefore, the back electrode 12 is divided into plural portions. The transparent electrode 9 serving as an anode is connected to a current source via a switch functioning as a column selector, and the back electrode 12 serving as a cathode is grounded via a switch functioning as a row selector. In this driving method, when one of the segments 8 is to emit light, the switch of the current source of the transparent electrode 9 corresponding to the segment 8 is turned ON, and the switch corresponding to the back electrode 12 is turned ON.

As a result, in the segment 8, electrons injected through the electron transporting layer, and holes injected through the hole transporting layer are recombined with one another in the light emitting layer to excite organic molecules. Light emission occurs in transition from the excited state to the ground state, thereby performing a predetermined display.

The optical filter 4 is configured by sequentially stacking a quarter-wave plate 15 and a polarizing plate 16 on the front face of the transparent substrate 2.

In the optical filter 4, extraneous light 17 which enters through a display face 14 is uniformalized in polarization direction by the polarizing plate 16, passes through the quarter-wave plate 15 to be reflected by the front face 18 of the back electrode 12, and then again passes through the quarter-wave plate 15, whereby the polarization direction of the light is caused to be perpendicular to that of the polarizing plate 16, so that the light is blocked by the polarizing plate 16 from exiting to the outside through the display face 14.

The sealing case 5 is made of, for example, a metal such as stainless steel, and bonded onto the transparent substrate 2 so as to cover the organic EL element 3. A moisture proofing agent 21 such as barium oxide is placed on an inner face of the sealing case. In order to prevent the moisture proofing agent 21 from scattering toward the organic EL element 3, the surface of the moisture proofing agent 21 is covered with an agent scatter preventing filter 22 formed by Teflon (trademark).

The visible light absorbing member 6 is placed on the front face of the agent scatter preventing filter 22, and formed by a black filter which is air-permeable so as not to impede the air permeability of the agent scatter preventing filter 22, and which easily absorbs visible light. Under this arrangement, the visible light absorbing member 6 is placed in a rear position with respect to a division gap 23 of the back electrode 12. Therefore, extraneous light 17a which enters through the display face 14 and then reaches the visible light absorbing member 6 is absorbed by the visible light absorbing member 6. Consequently, irregular reflection does not occur in the surface of the visible light absorbing member 6. As a result, a phenomenon that irregular reflection light passes through the division gap 23 (division line) of the back electrode 12 and then exits to the outside through the display face 14 is prevented from occurring.

In the thus configured organic EL display device 1, with respect to the extraneous light 17 and 17a which enters from the outside through the display face 14, the extraneous light 17 which is reflected by the front face 18 of the back electrode 12 to advance toward the display face 14 is blocked by the optical filter 4 as described above, so as not to exit to the outside, and the extraneous light 17a which passes through the organic EL element 3 and the division gap 23 of the back electrode 12 is absorbed by the visible light absorbing member 6 placed in a rear position with respect to the division gap 23 of the back electrode 12. Therefore, irregular reflection does not occur in the surface of the visible light absorbing member 6. As a result, a phenomenon that irregular reflection light passes through the division gap 23 of the back electrode 12 and then exits to the outside through the display face 14 does not occur, so that the division line of the back electrode 12 is prevented from being displayed by the irregular reflection light on the display face 14. Therefore, the visuality can be enhanced and the contrast of the display face can be improved.

In the embodiment, the visible light absorbing member 6 is formed separately from the agent scatter preventing filter 22, and placed on the front face of the filter. Alternatively, in place of using the dedicated visible light absorbing member 6, the agent scatter preventing filter 22 may be used as a visible light absorbing member with being colored with black so as to have a function of absorbing visible light.

In the embodiment, the moisture proofing agent 21 is placed on the inner face of the sealing case 5 and covered by the agent scatter preventing film 22, and hence the visible light absorbing member 6 is formed by an air-permeable film so as not to impede the air permeability of the agent scatter preventing film 22. In the case where the moisture proofing agent 21 is not disposed, the visible light absorbing member is not required to be air permeable. In this case, therefore, the visible light absorbing member 6 may be any one of black members which easily absorb light, including black paper, black nonwoven fabric, a resin into which a black pigment is mixed, and a resin a surface of which is colored with black, and may be directly bonded to the inner face of the sealing case 5.

According to the first aspect of the invention, since the visible right absorbing member is placed in a rear position with respect to the division line of the back electrode, extraneous light which enters through the front face (display face) of the transparent substrate and passes through the organic EL element and the division gap of the back electrode to reach the side of the inner face of the sealing member is absorbed by the visible light absorbing member. Therefore, the division line of the back electrode is prevented from being displayed on the display face, so that the visuality of the display device can be improved.

According to the second aspect of the invention, when black paper, black nonwoven fabric, a resin into which a black pigment is mixed, or a resin a surface of which is colored with black is used as the visible light absorbing member, the visible light absorbing member can be formed by a simple configuration.

According to the third aspect of the invention, in the case where a moisture, proofing agent is placed on the inner face of the sealing member, when a black filter is placed as the visible light absorbing member on the front face of the agent scatter preventing filter, extraneous light which enters through the front face (display face) of the transparent substrate and passes through the organic EL element and the division gap of the back electrode to reach the agent scatter preventing filter can be absorbed without lowering the air permeability of the agent scatter preventing filter.

According to the fourth aspect of the invention, in the case where a moisture proofing agent is placed on the inner face of the sealing member, a black agent scatter preventing filter is used as the visible light absorbing member, whereby extraneous light which enters through the front face (display face) of the transparent substrate and passes through the division gap of the back electrode to reach the agent scatter preventing filter can be absorbed without lowering the air permeability of the agent scatter preventing filter.

## Claims

1. An organic EL display device comprising:
a transparent substrate;
an organic EL element which is formed on said transparent substrate, and in which a non-transparent back electrode is dividedly formed;
a sealing member which is disposed on said transparent substrate to cover said organic EL element; and
a visible light absorbing member which is placed in a rear position with respect to a division line of said back electrode.

2. The organic EL display device according to claim 1, wherein
said visible light absorbing member is placed on an inner face of said sealing member, and is one of black paper, black nonwoven fabric, a resin into which a black pigment is mixed, and a resin a surface of which is colored with black.

3. The organic EL display device according to claim 1, wherein
said display device further comprises:
a moisture proofing agent which is placed on an inner face of said sealing member; and
an agent scatter preventing filter which is coveringly placed on a surface of said moisture proofing agent, and
said visible light absorbing member is formed as a black filter, and coveringly placed on said agent scatter preventing filter.

4. The organic EL display device according to claim 1, wherein
said display device further comprises:
a moisture proofing agent which is placed on an inner face of said sealing member, and
said visible light absorbing member is formed as a black agent scatter preventing filter, and coveringly placed on a surface of said moisture proofing agent.
